(19) Europäisches Patentamt
European Patent Office
Office européen des brevets

(11) **EP 3 835 115 A1**

(12) **EUROPEAN PATENT APPLICATION**

(43) Date of publication:
**16.06.2021 Bulletin 2021/24**

(21) Application number: **19215785.7**

(22) Date of filing: **12.12.2019**

(51) Int Cl.:
*B60L 58/12* (2019.01)    *B60L 58/16* (2019.01)
*G01R 31/367* (2019.01)    *G01R 31/3828* (2019.01)
*G01R 31/3835* (2019.01)    *G01R 31/387* (2019.01)
*G01R 31/392* (2019.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME
KH MA MD TN**

(71) Applicant: **Permobil AB
861 23 Timrå (SE)**

(72) Inventors:
• **WALTHER, Björn
864 91 Matfors (SE)**
• **ELIASSON, Mikael
78430 Borlänge (SE)**
• **BÄCKMAN, Adam
86334 Sörberge (SE)**

(74) Representative: **Kransell & Wennborg KB
P.O. Box 27834
115 93 Stockholm (SE)**

(54) **METHOD OF ESTIMATING THE REMAINING DRIVING DISTANCE AVAILABLE FROM A CHARGE FOR A POWERED MOBILITY DEVICE**

(57)    A method of estimating the remaining driving distance available from a current charge of a battery of an electrically powered mobility device, wherein the method comprises: a) determining a state of charge of the battery based on a measured battery-related parameter, b) determining a state of health of the battery based on the state of charge, and c) estimating the remaining driving distance that the mobility device can travel with the current charge based on the state of charge and the state of health.

Fig. 4

EP 3 835 115 A1

**Description**

**TECHNICAL FIELD**

The present disclosure generally relates to electrically powered mobility devices.

**BACKGROUND**

Electrically powered mobility devices such as wheelchairs comprise an electric motor powered by a battery pack. It facilitates for the users of mobility devices to be aware of how much charge is left in the battery pack at any moment. Thereby better route planning may for example be performed.

There are products on the market which display the remaining charge in the battery pack of wheelchairs. These products are however prone to provide incorrect information about the remaining charge in the battery pack. The battery charge status may for example jump up and down seemingly randomly. This renders existing battery indicators essentially useless.

**SUMMARY**

An object of the present disclosure is to provide a method which solves, or at least mitigates problems of the prior art.

Other objects are to provide a battery monitoring device, an electrically powered mobility device and a system.

There is hence according to a first aspect of the present disclosure provided a method of estimating the remaining driving distance available from a current charge of a battery of an electrically powered mobility device, wherein the method comprises: a) determining a state of charge of the battery based on a measured battery-related parameter, b) determining a state of health of the battery based on the state of charge, and c) estimating the remaining driving distance that the mobility device can travel with the current charge based on the state of charge and the state of health.

The estimation of the remaining driving distance may thereby be made more accurate. This may be obtained because the state of health of the battery is used for determining the remaining driving distance. The state of health is a measure of the present capacity of the battery in relation to its nominal capacity. The state of health is hence a measure of the health of the battery compared to its nominal capacity. The nominal capacity may for example be the nominal ampere hours of the battery.

A mobility device is a device that aids the movement of individuals with physical impairments. A mobility device may for example be a wheelchair, an electric cart, a scooter or a personal transporter.

The state of charge is a measure of the relative capacity of the battery that has been utilised. The state of health of the battery influences how the state of charge is to be interpreted for the purpose of estimating the remaining driving distance.

The remaining driving distance may be the instantaneous remaining driving distance.

According to one embodiment step b) involves determining the state of health based on actual consumed ampere hours of the battery.

According to one embodiment step b) involves determining the actual consumed ampere hours of the battery based on calculated consumed ampere hours.

Some mobility devices may be provided with an ampere meter configured to calculate the consumed ampere hours based on the battery load. For such implementations it is beneficial to determine the actual consumed ampere hours instead of using the calculated consumed ampere hours, to obtain a more accurate estimation of the remaining driving distance.

According to one embodiment the determining of the actual consumed ampere hours is further based on a power-on time which is the time the mobility device has been powered on with the current charge and a motor active time which is the time the motors of the mobility device have been active with the current charge.

According to one embodiment the state of health is determined further based on the nominal ampere hours of the battery.

According to one embodiment the state of health is determined based on a ratio between the actual consumed ampere hours and the state of charge times the nominal ampere hours.

According to one embodiment in step c) the remaining driving distance is estimated by multiplying the state of charge with the state of health and with the nominal ampere hours of the battery to obtain a product which is divided by an average power consumption of the battery.

The average power consumption of the battery may be determined by dividing the actual consumed ampere hours with the distance travelled by the mobility device with the current battery charge.

According to one embodiment the battery-related parameter is a battery voltage.

The battery voltage may be measured when the mobility device is turned off. This may be necessary in case the voltage measurement device is located relatively far from the battery, in which case the voltage drop due to the distance will render the voltage measurements unreliable when the mobility device is turned on.

The mobility device may be configured to start to measure the battery voltage after the mobility device has been turned off and the battery voltage exceeds a voltage threshold.

According to one embodiment the battery-related parameter is the number of hours that the battery has been charged to obtain the current charge.

There is according to a second aspect of the present disclosure provided a battery monitoring device comprising: processing circuitry, and a storage medium, wherein the storage medium comprises a computer program which when executed by the processing circuitry causes the battery monitoring device to perform the method according to the first aspect.

One embodiment comprises an input device configured to obtain the measured battery-related parameter from an electrically powered mobility device and to send the remaining driving distance to the electrically powered mobility device.

There is according to a third aspect of the present disclosure provided an electrically powered mobility device comprising a battery, a battery parameter measurement unit configured to measure a battery-related parameter of the battery, and a communications unit configured to send the measured battery-related parameter wirelessly to the battery monitoring device according to the second aspect, and to receive the remaining driving distance from the battery monitoring device.

One embodiment comprises a display configured to display the remaining driving distance.

According to one embodiment the electrically powered mobility device is a wheelchair.

There is according to a fourth aspect provided a system comprising: the electrically powered mobility device according to the third aspect, and a battery monitoring device according to the second aspect configured to communicate with the electrically powered mobility device.

The battery monitoring device may for example be a server. The battery monitoring device may form part of a cloud system. The battery monitoring device may be arranged remotely from the electrically powered mobility device.

Generally, all terms used in the claims are to be interpreted according to their ordinary meaning in the technical field, unless explicitly defined otherwise herein. All references to "a/an/the element, apparatus, component, means, etc." are to be interpreted openly as referring to at least one instance of the element, apparatus, component, means, etc., unless explicitly stated otherwise.

## BRIEF DESCRIPTION OF THE DRAWINGS

The specific embodiments of the inventive concept will now be described, by way of example, with reference to the accompanying drawings, in which:

Fig. 1 schematically shows an example of a system comprising a battery monitoring device and an electrically powered mobility device;

Fig. 2 schematically shows a block diagram of the battery monitoring system in Fig. 1;

Fig. 3 is a schematic block diagram of an example of a mobility device; and

Fig. 4 is a flowchart of a method of estimating the remaining driving distance available from a current charge of a battery of an electrically powered mobility device.

## DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

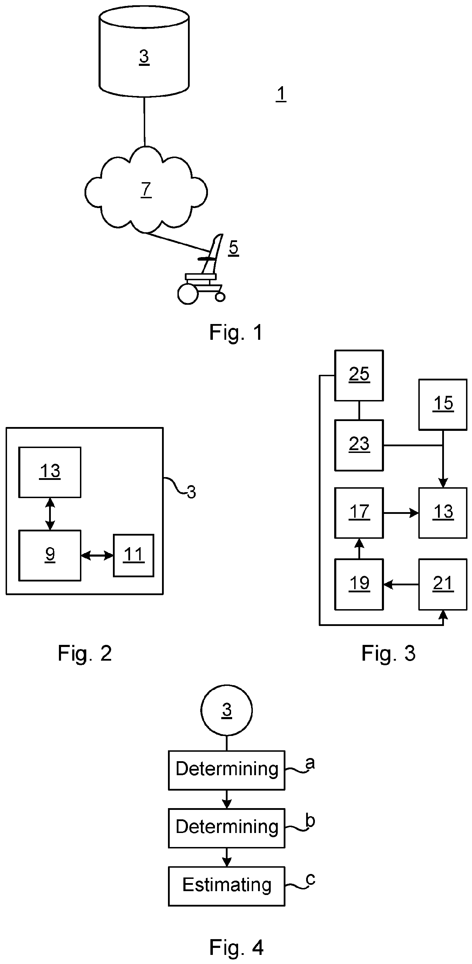

Fig. 1 shows an example of a system 1 including a battery monitoring device 3 and an electrically powered mobility device 5. The electrically powered mobility device 5 comprises an electric motor and a battery configured to power the electric motor.

The battery monitoring device 3 is configured to be communicatively connected to the mobility device 5 by means of a communications network 7. The communications network 7 may comprise an access network, which may be at least partly wireless, and which may include e.g. 3G, 4G, 5G, Wi-Fi or any similar technology, and a service network such as the Internet. The battery monitoring device 3 and the mobility device 5 are in this example configured to communicate wirelessly over the communications network 7.

The mobility device 5 is configured to measure a battery-related parameter of the battery. The battery-related parameter may for example be a battery voltage or the charging time of the battery.

The mobility device 5 is configured to send the measured battery-related parameter to the battery monitoring device 3 via the communications network 7.

The battery monitoring device 3 is configured to receive the measured battery-related parameter from the mobility device 5 and to process the measured battery-related parameter.

The battery monitoring device 3 is configured to estimate the remaining driving distance that the mobility device 5 can travel with the current charge based on the measured battery-related parameter. Further, the battery monitoring device 3 is configured to send the estimated remaining driving distance to the mobility device 5.

The mobility device 5 is configured to present the estimated remaining driving distance to the user. For example, the mobility device 5 may comprise a display configured to display the estimated remaining driving distance.

As an alternative to the above distributed example, the battery monitoring device could form part of the mobility device. The battery monitoring device could hence be mounted to the mobility device.

Fig. 2 schematically shows a block diagram of the battery monitoring device 3. The battery monitoring device 3 comprises processing circuitry 9 and an input device and an output device together denoted by 11. The input device and the output device are configured to communicate with the processing circuitry 9 and with the mobility device 5. Depending on the implementation of the processing circuitry 9, the battery monitoring device 3 may comprise a storage medium 11.

The processing circuitry may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning the estimation of the remaining driving distance that the mobility device can travel with the current charge.

The storage medium may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

Fig. 3 shows a block diagram of components of the mobility device 5. The mobility device 5 comprises an electric motor system 13, typically comprising electric motors configured to drive a respective drive wheel, a battery 15, power converters 17, and a control system 19. The battery 15 is configured to power the electric motor system 13. The power converters 17 are configured to control a respective electric motor. The control system 19 is configured to control the power converters 17. The mobility device 5 furthermore comprises a user interface 21 with which the user can interact for controlling the electric motors via the control system 19.

The mobility device 5 comprises a battery parameter measurement unit 23 configured to measure a battery-related parameter of the battery 15. The battery parameter measurement unit 23 may for example comprise a volt meter configured to measure the battery voltage of the battery 15. The battery parameter measurement unit 23 may according to one variation comprise a timer configured to determine the time that that the battery 15 has been charging. The timer may be configured to start counting in case the battery voltage measured by the volt meter exceeds a voltage that the battery 15 is able to provide in operation of the mobility device 5. When the timer has counted to a predetermined number, it gives an indication that the battery 15 is fully charged.

In case the volt meter is located at such a distance from the battery 15 that the volt meter is not able to measure the battery voltage with good precision due to the voltage drop over the electric wiring between the battery 15 and the volt meter, the battery parameter measurement unit 23 may be configured to measure the battery voltage when the mobility device 5 has been turned off.

The mobility device 5 is configured to send the measured battery-related parameter to the battery monitoring device 3. The mobility device 5 comprises a communications unit 25 configured to send the measured battery-related parameter to the battery monitoring device 3 and to receive the remaining driving distance from the battery monitoring device 3.

Fig. 4 shows a flowchart of a method of estimating the remaining driving distance available from a current charge of the battery of the mobility device 5. The method is performed by the battery monitoring device 3.

As previously noted, the battery-related parameter is measured by the mobility device 5 and sent to the battery monitoring device 3.

In a step a) a state of charge of the battery is determined based on the measured battery-related parameter. The measured battery-related parameter may for example be compared with reference values of the battery-related parameter to determine the state of charge. Each reference value may be associated with a certain state of charge.

In case the battery-related parameter is the battery voltage, it can be compared to historical or reference battery voltage levels to determine the state of charge in step a).

In case the battery parameter measurement unit 23 is configured to measure the time of charging, the measured batter-related parameter may be the time of charging. The battery monitoring device 3 may be configured to compare the time of charging with reference times of charging to determine the state of charge.

According to one variation, the battery monitoring device 3 may be configured to obtain a battery temperature and an ambient temperature around the battery. The determining in step a) may in this case further be based on the battery temperature and the ambient temperature. In this case, the determining may involve comparing the battery-related parameter with historical or reference values that are further dependent of the battery temperature and ambient temperature. For example, in case the battery-related parameter is the battery voltage, it can be compared to historical or reference battery voltage levels at the corresponding battery temperature and ambient temperature.

The mobility device may in this case be provided with a temperature sensor configured to detect the battery temperature. The mobility device may be provided with a temperature sensor configured to detect the ambient temperature.

According to one variation, the battery monitoring device 3 may be configured to obtain the ambient temperature around the battery based on a position of the mobility device from a service provider such as Google®.

In a step b) the state of health of the battery is determined based on the state of charge.

Step b) may involve determining the state of health based on the actual consumed ampere hours of the battery.

For some mobility devices on the market provided with ampere meters, the ampere meter may not actually measure the consumed current but only provide a calculated current consumption based on the load. Such calculations may also in some cases only take the current consumed by the motors and not those of peripheral devices into account. The calculated current consumption may therefore not exactly correspond to the actual current consumption. The actual consumed ampere hours may be determined based on the calculated current consumption.

The mobility device 5 is in this case configured to calculate the current consumed from the battery 15. The mobility device 5 may for example comprise an ampere meter configured to calculate the consumed current.

Step b) may in this case involve determining the actual consumed ampere hours of the battery based on calculated consumed ampere hours.

The mobility device 5 may be configured to send the calculated consumed ampere hours or the actual consumed ampere hours to the battery monitoring device 3. Alternatively, the mobility device 5 may be configured to send calculated accumulated current and the time that the mobility device 5 has been active to the battery monitoring device 3. The battery monitoring device 3 may in this case be configured to act as an ampere hour counter to determine the actual consumed ampere hours based on the calculated accumulated current and the time. The calculated accumulated current multiplied by the time that the mobility device 5 has been active to the battery monitoring device 3 form the calculated consumed ampere hours.

In case of dealing with calculated consumed ampere hours, the actual consumed ampere hours may in step b) be determined further based on a power-on time $t_{on}$ which is the time the mobility device has been powered on with the current charge, and based on the motor active time $t_{motoractive}$, which is the time the electric motors of the mobility device 5 have been active under the current charge. Specifically, the actual consumed ampere hours $Ih_{real}$ may be determined by means of equation (1) below.

$$Ih_{real} = C^* Ih_{calc} + D^* t_{motoractive} + E^* t_{on} \tag{1}$$

where C, D and E are constants which can be determined by curve-fitting and $Ih_{calc}$ is the calculated consumed ampere hours.

The mobility device 5 may be configured to send the power-on time $t_{on}$ and the motor active time $t_{motoractive}$ to the battery monitoring device 3.

In case the mobility device 5 is configured to measure the actual consumed ampere hours, the measured actual consumed ampere hours may be used as the actual consumed ampere hours in step b).

In step b) the determining of the state of health may further involve determining a ratio between the actual consumed ampere hours and the nominal ampere hours of the battery 15. The numerator of the ratio i.e. the nominal ampere hours of the battery 15 may be scaled using the state of charge at start, i.e. at full charge, minus the present state of charge. Thus, the state of health, SOH, may be determined by equation (2) below.

$$SOH = \frac{Ih_{real}}{(SOC_{start} - SOC_{present})Ih_{batterycapacity}} \tag{2}$$

where $Ih_{batterycapacity}$ is the nominal ampere hours of the battery 15, $SOC_{start}$ is the state of charge at start and $SOC_{present}$

is the present state of charge determined in step a).

In a step c) the remaining driving distance that the mobility device can travel with the current charge is estimated based on the state of charge and the state of health.

The remaining driving distance may be estimated by multiplying the state of charge with the state of health and with the nominal ampere hours of the battery 15 to obtain a product $P=SOH*SOC_{present}*Ih_{batterycapacity}$, which is divided by the average power consumption e of the battery 15. The remaining driving distance davailabie may hence be estimated by means of equation (3).

$$d_{available} = \frac{SOC_{present} \cdot SOH \cdot Ih_{batterycapacity}}{e} \qquad (3)$$

The average power consumption e of the battery 15 may be determined by dividing the actual consumed ampere hours $I_{hreal}$ with the distance travelled by the mobility device 5 with the current charge. The distance travelled with the current charge may be sent to the battery monitoring device 3. The average power consumption e is in the present example expressed in units Ah/m.

As mentioned earlier, the battery monitoring device 3 is configured to send the remaining driving distance $d_{available}$ to the mobility device 5. The mobility device 5 is configured to present the remaining driving distance to the user via the user interface 21. For example, the user interface 21 may comprise a display configured to display the remaining driving distance.

By means of the remaining driving distance presented to the user, the user of the mobility device 5 may obtain more accurate information regarding how far the mobility device 5 at essentially any given moment is able to travel with the charge available in the battery 15. The user is thereby able to perform route planning more accurately than what has previously been possible.

According to one variation, the battery monitoring system may be configured to detect if the state of charge has dropped below for example 40% or below 30% in combination with mobility device having been turned off for a plurality of days such as at least 3 days, at least 4 days or at least 5 days. In this case, the battery monitoring system may be configured to provide an alarm. The alarm may be triggered again when the state of charge drops below for example 15%, 10% and 5%. The alarm may be provided to the mobility device.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A method of estimating the remaining driving distance available from a current charge of a battery (15) of an electrically powered mobility device (5), wherein the method comprises:

   a) determining a state of charge of the battery (15) based on a measured battery-related parameter,
   b) determining a state of health of the battery (15) based on the state of charge, and
   c) estimating the remaining driving distance that the mobility device (5) can travel with the current charge based on the state of charge and the state of health.

2. The method as claimed in claim 1, wherein step b) involves determining the state of health based on actual consumed ampere hours of the battery (15).

3. The method as claimed in claim 2, wherein step b) involves determining the actual consumed ampere hours of the battery (15) based on calculated consumed ampere hours.

4. The method as claimed in claim 3, wherein the determining of the actual consumed ampere hours is further based on a power-on time which is the time the mobility device (15) has been powered on with the current charge and a motor active time which is the time the motors of the mobility device (15) have been active with the current charge.

5. The method as claimed in any claim 2-4, wherein the state of health is determined further based on the nominal ampere hours of the battery.

6. The method as claimed in claim 5, wherein the state of health is determined based on a ratio between the actual consumed ampere hours and the state of charge times the nominal ampere hours.

7. The method as claimed in any of the preceding claims, wherein in step c) the remaining driving distance is estimated by multiplying the state of charge with the state of health and with the nominal ampere hours of the battery (15) to obtain a product which is divided by an average power consumption of the battery (15).

8. The method as claimed in any of the preceding claims, wherein the battery-related parameter is a battery voltage.

9. The method as claimed in any of claims 1-7, wherein the battery-related parameter is the number of hours that the battery (15) has been charged to obtain the current charge.

10. A battery monitoring device (3) comprising:

    processing circuitry (9), and
    a storage medium (13),
    wherein the storage medium (13) comprises a computer program which when executed by the processing circuitry causes (9) the battery monitoring device (3) to perform the method as claimed in any of claims 1-9.

11. The battery monitoring device (3) as claimed in claim 10, comprising an input device configured to obtain the measured battery-related parameter from an electrically powered mobility device (5), and an output device configured to send the remaining driving distance to the electrically powered mobility device (5).

12. An electrically powered mobility device (5) comprising a battery (15), a battery parameter measurement unit (23) configured to measure a battery-related parameter of the battery (15), and a communications unit (25) configured to send the measured battery-related parameter wirelessly to the battery monitoring device (3) as claimed in claim 10 or 11, and to receive the remaining driving distance from the battery monitoring device (3).

13. The electrically powered mobility device (5) as claimed in claim 12, comprising a display configured to display the remaining driving distance.

14. The electrically powered mobility device (5) as claimed in any of claims 12-13, wherein the electrically powered mobility device (5) is a wheelchair.

15. A system (1) comprising:

    the electrically powered mobility device (5) as claimed in any of claims 12-14, and
    a battery monitoring device (3) as claimed in claim 10 or 11 configured to communicate with the electrically powered mobility device (5).

Fig. 1

Fig. 2

Fig. 3

Fig. 4

Europäisches
Patentamt

European
Patent Office

Office européen
des brevets

# EUROPEAN SEARCH REPORT

Application Number

EP 19 21 5785

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2012/256599 A1 (GU JAE-SUNG [KR])<br>11 October 2012 (2012-10-11)<br>* paragraphs [0011], [0058], [0059] * | 1-6,<br>8-13,15<br>7,14 | INV.<br>B60L58/12<br>B60L58/16<br>G01R31/367 |
| Y<br><br>A | CN 110 406 427 A (SICHUAN YEMA AUTOMOBILE CO LTD) 5 November 2019 (2019-11-05)<br>* paragraphs [0019], [0033], [0041], [0053], [0060], [0067] * | 7<br><br>1-6,8-15 | G01R31/3828<br>G01R31/3835<br>G01R31/387<br>G01R31/392 |
| Y<br>A | CN 106 427 579 A (EONTRONIX CO LTD)<br>22 February 2017 (2017-02-22)<br>* paragraph [0066] * | 7<br>1-6,8-15 | |
| Y<br><br><br><br><br><br><br><br><br><br>A | AYLOR J H ET AL: "A BATTERY STATE-OF-CHARGE INDICATOR FOR ELECTRIC WHEELCHAIRS",<br>IEEE TRANSACTIONS ON INDUSTRIAL ELECTRONICS, IEEE SERVICE CENTER, PISCATAWAY, NJ, USA,<br>vol. 39, no. 5,<br>1 October 1992 (1992-10-01), pages 398-409, XP000320622,<br>ISSN: 0278-0046, DOI: 10.1109/41.161471<br>* abstract *<br>* figures 1,7 *<br>* page 402, paragraph 2 * | 14<br><br><br><br><br><br><br><br><br><br>1-13,15 | TECHNICAL FIELDS SEARCHED (IPC)<br><br>B60L<br>G01R |
| A | EP 3 369 604 A1 (BEIJING ELECTRIC VEHICLE CO LTD [CN]) 5 September 2018 (2018-09-05)<br>* figures 1-5 *<br>* paragraphs [0003], [0008] - [0015], [0019], [0045], [0046], [0058], [0059], [0071] * | 1-15 | |
| A | US 2018/109121 A1 (UCHIDA MASATOSHI [JP])<br>19 April 2018 (2018-04-19)<br>* figures 1,2,8 *<br>* paragraphs [0013], [0018] - [0019] * | 1-15 | |

-/--

The present search report has been drawn up for all claims

| Place of search | Date of completion of the search | Examiner |
|---|---|---|
| The Hague | 30 June 2020 | Gücin, Taha |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 19 21 5785

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/294173 A1 (SZUBBOCSEV ZOLTAN [DE]) 26 September 2019 (2019-09-26) * figures 6-10 * * paragraphs [0030], [0085] - [0087] * | 1-15 | |

TECHNICAL FIELDS
SEARCHED      (IPC)

The present search report has been drawn up for all claims

| Place of search | Date of completion of the search | Examiner |
|---|---|---|
| The Hague | 30 June 2020 | Gücin, Taha |

EPO FORM 1503 03.82 (P04C01)

page 2 of 2

## ANNEX TO THE EUROPEAN SEARCH REPORT
## ON EUROPEAN PATENT APPLICATION NO.

EP 19 21 5785

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2020

| Patent document cited in search report | | Publication date | Patent family member(s) | | Publication date |
|---|---|---|---|---|---|
| US 2012256599 | A1 | 11-10-2012 | KR 20120114584 A<br>US 2012256599 A1 | | 17-10-2012<br>11-10-2012 |
| CN 110406427 | A | 05-11-2019 | NONE | | |
| CN 106427579 | A | 22-02-2017 | NONE | | |
| EP 3369604 | A1 | 05-09-2018 | CN 105365592 A<br>EP 3369604 A1<br>WO 2017071657 A1 | | 02-03-2016<br>05-09-2018<br>04-05-2017 |
| US 2018109121 | A1 | 19-04-2018 | CN 107953786 A<br>EP 3309892 A1<br>JP 6414580 B2<br>JP 2018063906 A<br>KR 20180041570 A<br>US 2018109121 A1 | | 24-04-2018<br>18-04-2018<br>31-10-2018<br>19-04-2018<br>24-04-2018<br>19-04-2018 |
| US 2019294173 | A1 | 26-09-2019 | US 2019294173 A1<br>WO 2019183222 A1 | | 26-09-2019<br>26-09-2019 |

EPO FORM P0459

For more details about this annex : see Official Journal of the European Patent Office, No. 12/82